# EUROPÄISCHE PATENTSCHRIFT

(11) **EP 3 693 591 B1**
(45) Veröffentlichungstag und Bekanntmachung des Hinweises auf die Patenterteilung: **05.04.2023**
(21) Anmeldenummer: 20155263.5
(22) Anmeldetag: 04.02.2020
(51) Int. Cl.: F02G 5/02, F01K 23/06, F01N 5/00

(54) **ABWÄRMENUTZUNG**
DRIVE UNIT FOR A MOTOR VEHICLE WITH COMBINED ARRANGEMENT OF A CIRCUIT PROCESS DEVICE AND A THERMOELECTRIC GENERATOR
UNITÉ D'ENTRAÎNEMENT POUR UN VÉHICULE AUTOMOBILE DOTÉE D'UN AGENCEMENT COMBINÉ D'UN DISPOSITIF DE PROCÉDÉ DE CIRCUIT ET D'UN GÉNÉRATEUR THERMOÉLECTRIQUE

(30) Priorität: 08.02.2019 DE 102019201685
(43) Veröffentlichungstag der Anmeldung: 12.08.2020
(73) Patentinhaber: VOLKSWAGEN AG, 38440 Wolfsburg (DE)
(72) Erfinder: Naumann, Hardy, 38442 Wolfsburg (DE); Carstensen, Asmus, 38557 Osloß (DE); Semke, Artur, 38446 Wolfsburg (DE)

(56) Entgegenhaltungen:
- DE-A1-102010 038 314
- DE-A1-102010 048 887
- DE-A1-102010 048 888
- DE-A1-102012 206 085
- DE-A1-102014 001 819
- US-A1- 2011 067 742

## Beschreibung

Die Erfindung betrifft eine Antriebseinheit für ein Kraftfahrzeug und ein Kraftfahrzeug mit einer solchen Antriebseinheit.

Kraftfahrzeuge werden häufig mittels Verbrennungsmotoren angetrieben, in denen Kraftstoffe verbrannt und die dabei freigesetzte Wärmeenergie teilweise in mechanische Arbeit umgewandelt wird. Der Wirkungsgrad von Hubkolben-Verbrennungsmotoren, die für den Antrieb von Kraftfahrzeugen nahezu ausschließlich eingesetzten werden, liegt gemittelt bei ca. einem Drittel der eingesetzten Primärenergie. Demnach stellen zwei Drittel der bei der Verbrennung freigesetzten Wärmeenergie Abwärme dar, die entweder über ein Kühlsystem des Kraftfahrzeugs oder über das von dem Abgasstrang ausgestoßene als Verlustwärme an die Umgebung abgegeben wird.

Eine Nutzung dieser Abwärme stellt eine Möglichkeit dar, den Gesamtwirkungsgrad einer Antriebseinheit des Kraftfahrzeugs zu steigern und damit den Kraftstoffverbrauch zu senken.

Bekannt ist, zur Nutzung von Abwärme eines Verbrennungsmotors eine Dampfkreisprozessvorrichtung oder einen thermoelektrischen Generator zu verwenden, wobei mittels dieser Vorrichtungen insbesondere Abwärme von Abgas des Verbrennungsmotors genutzt werden kann (vgl. DE 10 2014 015 457 A1 oder DE 10 2014 001 819 A1).

Die DE 10 2010 048 887 A1 offenbart diesbezüglich eine kombinierte Verwendung einer Dampfkreisprozessvorrichtung und eines thermoelektrischen Generators zur Nutzung von Abwärme eines Verbrennungsmotors. Dabei ist der thermoelektrische Generator über eine Kühlfluidleitung wärmeleitend mit der Kreisprozessvorrichtung verbunden. Dies ermöglicht, Abwärme der Dampfkreisprozessvorrichtung teilweise in dem thermoelektrischen Generator durch Umwandlung in elektrische Energie zu nutzen.

Die DE 10 2010 048 888 A1 offenbart eine Antriebseinheit, bei der sowohl die Hochtemperaturseite als auch die Niedertemperaturseite eines thermoelektrischen Generators in eine Kreisprozessvorrichtung integriert sind und damit von dem Arbeitsmedium der Kreisprozessvorrichtung durchströmt werden.

Die DE 10 2010 038 314 A1 offenbart eine dazu ähnliche Antriebseinheit, bei der jedoch der Verdampfer der Kreisprozessvorrichtung mit einem thermoelektrischen Generator kombiniert ist, wobei die Niedertemperaturseite des thermoelektrischen Generators von dem Arbeitsmedium der Kreisprozessvorrichtung durchströmt wird.

Der Erfindung lag die Aufgabe zugrunde, eine bessere Nutzung von Abwärme eines Verbrennungsmotors eines Kraftfahrzeugs zu ermöglichen.

Diese Aufgabe wird mittels einer Antriebseinheit gemäß dem Patentanspruch 1 gelöst. Ein Kraftfahrzeug mit einer solchen Antriebseinheit ist Gegenstand des Patentanspruchs 11. Vorteilhafte Ausgestaltungsformen der erfindungsgemäßen Antriebseinheit und damit auch des erfindungsgemäßen Kraftfahrzeugs sind Gegenstände der weiteren Patentansprüche und/oder ergeben sich aus der nachfolgenden Beschreibung der Erfindung.

Erfindungsgemäß ist eine Antriebseinheit für ein Kraftfahrzeug sowie ein Kraftfahrzeug mit einer solchen Antriebseinheit vorgesehen, wobei die Antriebseinheit einerseits eine Brennkraftmaschine aufweist, die einen Verbrennungsmotor sowie einen Abgasstrang, über den Abgas von dem Verbrennungsmotor abführbar ist, umfasst.

Weiterhin weist die Antriebseinheit eine Kreisprozessvorrichtung auf, die zur Wandlung von Wärmeenergie des Abgases in einem (rechtsläufigen) thermodynamischen Kreisprozess in mechanische Arbeit eingerichtet ist, wobei ein Arbeitsmedium bezüglich seiner Strömungsrichtung eine erste Wärmetauschvorrichtung durchströmt, in der ein (direkter oder indirekter) Wärmeübergang von dem Abgas auf das Arbeitsmedium erfolgt, wodurch die Temperatur und/oder der Druck des Arbeitsmediums erhöht wird. Anschließend durchströmt das Arbeitsmedium eine Expansionsvorrichtung, in der eine Expansion des Arbeitsmediums und dabei die Erzeugung der mechanischen Arbeit erfolgt. Daraufhin durchströmt das Arbeitsmedium noch eine zweite Wärmetauschvorrichtung, in der ein (direkter oder indirekter) Wärmeübergang von dem Arbeitsmedium auf ein Kühlmedium erfolgt.

Eine erfindungsgemäße Antriebseinheit umfasst zudem einen thermoelektrischen Generator (TEG), der zur Wandlung von Wärmeenergie des Abgases in elektrische Energie eingerichtet ist und der dazu bei einer Temperaturdifferenz zwischen seiner Hochtemperaturseite und seiner Niedertemperaturseite eine elektrische Spannung bereitstellt. Hierzu umfasst der TEG in bekannter Weise mindestens ein Thermoelement, üblicherweise eine Vielzahl von Thermoelementen, bei dem/denen gemäß dem thermoelektrischen Effekt (auch "Seebeck-Effekt" genannt) in einem Stromkreis, der aus zwei verschiedenen elektrischen Leitern ausgebildet ist, bei einer Temperaturdifferenz zwischen den Kontaktstellen dieser elektrischen Leiter eine elektrische Spannung anliegt. Die elektrischen Leiter können dabei vorzugsweise aus Metallen und insbesondere aus Halbleitern ausgebildet sein. Solche TEG ermöglichen eine direkte Umwandlung von Wärmeenergie in elektrische Energie. Um die für die Funktionsfähigkeit eines TEG erforderliche Temperaturdifferenz zwischen den Kontaktstellen der elektrischen Leiter dauerhaft bereitzustellen, umfasst ein solcher TEG demnach einen mit einem Ende der elektrischen Leiter wärmeleitend verbundenen ersten Wärmetauscher, nachfolgend als Hochtemperaturseite des TEG bezeichnet, mittels dessen durch einen gezielten Wärmeübergang eine relativ hohe Temperatur dieser Enden der elektrischen Leiter eingestellt wird, sowie einen mit dem jeweils anderen Ende der elektrischen Leiter verbundenen zweiten Wärmetauscher, nachfolgend als Niedertemperaturseite des TEG bezeichnet, in dem durch eine gezielte Wärmeabführung beziehungsweise Kühlung eine relativ niedrige Temperatur für die dazugehörigen Enden der elektrischen Leiter eingestellt wird.

ist Eine Integration des TEG in die Kreisprozessvorrichtung ist derart vorgesehen, dass das Arbeitsmedium auch über diesen geführt wird oder werden kann. Dadurch kann in besonders vorteilhafter Weise eine thermische Kopplung der Kreisprozessvorrichtung und des TEG realisiert werden, die sich positiv hinsichtlich des Gesamtwirkungsgrads der Abwärmenutzung und/oder hinsichtlich der konstruktiven und räumlichen Kombination dieser beiden Vorrichtungen auswirkt.

Erfindungsgemäß ist das Arbeitsmedium über die Hochtemperaturseite des TEG führbar. Eine Kühlung der Niedertemperaturseite des TEG erfolgt mittels eines sich von dem Arbeitsmedium unterscheidenden Kühlmittels, insbesondere mittels des auch zur Kühlung in der zweiten Wärmetauschvorrichtung der Kreisprozessvorrichtung genutzten Kühlmediums und/oder mittels gezielt zugeführter Umgebungsluft. Eine solche erfindungsgemäße Ausgestaltung einer Antriebseinheit basiert insbesondere darauf, eine noch relativ hohe Temperatur des Arbeitsmediums zur Realisierung einer möglichst großen Temperaturdifferenz zwischen der Hochtemperaturseite und der Niedertemperaturseite des TEG auszunutzen. Hierzu kann der TEG beziehungsweise die Hochtemperaturseite davon bezüglich der Strömungsrichtung des Arbeitsmediums vorzugsweise entweder stromab der Expansionsvorrichtung und stromauf der zweiten Wärmetauschvorrichtung oder stromab der ersten Wärmetauschvorrichtung und stromauf der Expansionsvorrichtung angeordnet beziehungsweise in den Kreislauf für das Arbeitsmedium der Kreisprozessvorrichtung integriert sein.

Der ersten dieser alternativen Anordnungen liegt dabei die Annahme zugrunde, dass die Temperatur des Arbeitsmediums auch nach der Expansionsvorrichtung noch ausreichend hoch ist, um für den TEG eine vorteilhaft hohe Temperaturdifferenz zwischen der Hochtemperaturseite und der Niedertemperaturseite zu generieren. Gleichzeitig kann ein Kühlen und insbesondere Kondensieren des Arbeitsmediums in der zweiten Wärmetauschvorrichtung der Kreisprozessvorrichtung praktisch begrenzt sein. Durch eine Anordnung des TEG stromab der Expansionsvorrichtung und stromauf der zweiten Wärmetauschvorrichtung bewirkt dieser eine zusätzliche Kühlleistung für das Arbeitsmedium und bewirkt somit eine Unterstützung für die zweite Wärmetauschvorrichtung, wodurch eine insgesamt ausreichende Kühlung und insbesondere Kondensation des Arbeitsmediums in der zweiten Wärmetauschvorrichtung auch bei einer relativ kleinen Dimensionierung der zweiten Wärmetauschvorrichtung erreicht werden kann.

Die zweite dieser alternativen Anordnungen des TEG beziehungsweise von dessen Hochtemperaturseite kann insbesondere dann vorgesehen sein, wenn eine Leistungsauslegung der Expansionsvorrichtung nicht auf der Basis eines im Betrieb der Antriebseinheit zu erwartenden maximalen Wärmestroms, der in der ersten Wärmetauschvorrichtung der Kreisprozessvorrichtung auf das Arbeitsmedium übertragbar ist, vorgenommen wird, sondern auf Basis eines im Vergleich dazu niedrigeren, insbesondere durchschnittlichen Wärmestroms, wodurch über sämtliche Betriebszustände der Antriebseinheit ein insgesamt besserer Wirkungsgrad der Kreisprozessvorrichtung realisiert werden kann. Der TEG kann dann insbesondere auch dazu genutzt werden, bei einem Betrieb der Antriebseinheit mit einem Wärmestrom, der größer als derjenige ist, für den die Expansionsvorrichtung ausgelegt ist, die überschüssige Wärmeleistung mittels des TEG zu nutzen, so dass beispielsweise auf eine Abriegelung der Leistung der Kreisprozessvorrichtung zur Vermeidung einer Überlastung der Expansionsvorrichtung verzichtet werden kann. Ein weiterer Vorteil dieser zweiten Anordnung des TEG kann in der noch relativ hohen Temperatur des Arbeitsmediums beim Strömen über die Hochtemperaturseite des TEG und damit in einer entsprechend hohen Temperaturdifferenz dieser Hochtemperaturseite gegenüber der Niedertemperaturseite liegen. Dies wirkt sich vorteilhaft hinsichtlich der von dem TEG bereitgestellten elektrischen Leistung aus.

Bei dem Abgas, dessen Abwärme genutzt werden soll, kann es sich insbesondere um solches Abgas handeln, das zumindest teilweise, vorzugsweise vollständig für ein Abführen in die Umgebung vorgesehen ist.

Vorzugsweise ist vorgesehen, dass es sich bei der Kreisprozessvorrichtung um eine Dampfkreisprozessvorrichtung handelt, die insbesondere zur Durchführung eines und insbesondere um eine Clausius-Rankine-Kreisprozesses eingerichtet ist, und bei der das Arbeitsmedium im flüssigen Zustand mittels einer Pumpe druckerhöht wird, anschließend in der ersten Wärmetauschvorrichtung verdampft und vorzugsweise überhitzt wird und in der zweiten Wärmetauschvorrichtung kondensiert wird.

Bei dem Kühlmedium, das zumindest in der zweiten Wärmetauschvorrichtung der Kreisprozessvorrichtung zum Abführen von Wärmeenergie genutzt wird, kann es sich um eine Kühlflüssigkeit handeln, die in einem Kühlsystem der Brennkraftmaschine und insbesondere in einem mindestens einen Kühlkanal des Verbrennungsmotors umfassenden Motorkühlkreis dieses Kühlsystems zirkuliert, handeln. Dadurch wird u.a. ermöglicht, die Abwärme des Kreisprozesses, die einen Großteil (z.B. ca. 85%) der zugeführten Wärmeenergie darstellen kann, auf einfache Weise über einen Kühlflüssigkeitskühler des Kühlsystems an die Umgebungsluft abzuführen. Alternativ oder ergänzend kann aber auch vorgesehen sein, Umgebungsluft zur Kühlung des Arbeitsmediums mittels der zweiten Wärmetauschvorrichtung zu nutzen.

Gemäß einer bevorzugten Ausgestaltungsform einer erfindungsgemäßen Antriebseinheit kann eine Integration des TEG in die Kreisprozessvorrichtung derart vorgesehen sein, dass das Kühlmedium, das für eine Wärmeabfuhr in der zweiten Wärmetauschvorrichtung der Kreisprozessvorrichtung genutzt wird, auch über die Niedertemperaturseite des TEG geführt wird/werden kann, um diese zu kühlen. Ergänzend oder alternativ kann jedoch auch eine Kühlung der Niedertemperaturseite des thermoelektrischen Generators mittels eines von dem Kühlmedium abweichenden Kühlmittels, insbesondere eines Gases, dann besonders bevorzugt mittels gezielt zugeführter Umgebungsluft, vorgesehen sein. Dadurch kann gegebenenfalls eine relativ große Temperaturdifferenz zwischen der Hochtemperaturseite und der Niedertemperaturseite des thermoelektrischen Generators realisiert werden. Dies gilt insbesondere, wenn das alternativ oder ergänzend genutzte Kühlmittel eine geringere Fluidtemperatur im Vergleich zu dem Kühlmedium aufweist.

Gemäß einer bevorzugten Ausgestaltungsform einer erfindungsgemäßen Antriebseinheit kann vorgesehen sein, dass die erste Wärmetauschvorrichtung und der TEG in einer Wärmetauscheinheit integriert ausgebildet sind. Dadurch kann eine möglichst kompakte Ausgestaltung der Antriebseinheit realisiert werden.

Für eine solche integrale Ausgestaltung kann insbesondere vorgesehen sein, dass in der Wärmetauscheinheit ein zur Durchströmung mit dem Arbeitsmedium vorgesehener Arbeitsmediumkanal der ersten Wärmetauschvorrichtung zwischen einem zur Durchströmung mit dem Abgas vorgesehenen Abgaskanal einerseits und der Hochtemperaturseite des TEG andererseits angeordnet ist. Das in den Arbeitsmediumkanal strömende Arbeitsmedium kann dadurch als Wärmedämpfer für die Hochtemperaturseite des TEG dienen, wodurch dieser vor temporären Temperaturspitzen des Abgases, die für dessen Haltbarkeit schädlich sein können, geschützt sein kann.

In konstruktiv vorteilhafter Weise kann eine solche Wärmetauscheinheit dadurch ausgebildet sein, dass der Arbeitsmediumkanal den Abgaskanal umfangsseitig umgibt und die Hochtemperaturseite des thermoelektrischen Generators den Arbeitsmediumkanal umfangsseitig umgibt beziehungsweise begrenzt. Weiterhin bevorzugt kann dann noch vorgesehen sein, dass die Niedertemperaturseite und insbesondere ein Kühlkanal davon, der zur Durchströmung mit einem Kühlmittel vorgesehen ist, die Hochtemperaturseite des TEG umfangsseitig umgibt.

Bei einem erfindungsgemäßen Kraftfahrzeug kann es sich insbesondere um ein radbasiertes und nicht schienengebundenes Kraftfahrzeug, vorzugsweise um einen PKW oder einen LKW, handeln. Dabei kann zumindest die Brennkraftmaschine der erfindungsgemäßen Antriebseinheit des Kraftfahrzeugs vorzugsweise zur direkten oder indirekten Bereitstellung der Fahrantriebsleistung für das Kraftfahrzeug vorgesehen sein.

Die Erfindung wird nachfolgend anhand von in den Zeichnungen dargestellten Ausgestaltungsbeispielen näher erläutert. Die Zeichnungen zeigen, jeweils in vereinfachter Darstellung:
- Fig. 1:: ein Kraftfahrzeug mit einer erfindungsgemäßen Antriebseinheit;
- Fig. 2:: eine erfindungsgemäße Antriebseinheit gemäß einer ersten Ausgestaltungsform;
- Fig. 3:: eine erfindungsgemäße Antriebseinheit gemäß einer zweiten Ausgestaltungsform;
- Fig. 4:: eine Antriebseinheit gemäß einer dritten Ausgestaltungsform;
- Fig. 5:: eine erfindungsgemäße Antriebseinheit gemäß einer vierten Ausgestaltungsform; und
- Fig. 6:: einen Querschnitt durch eine Wärmetauscheinheit für eine Antriebseinheit gemäß der Fig. 5.

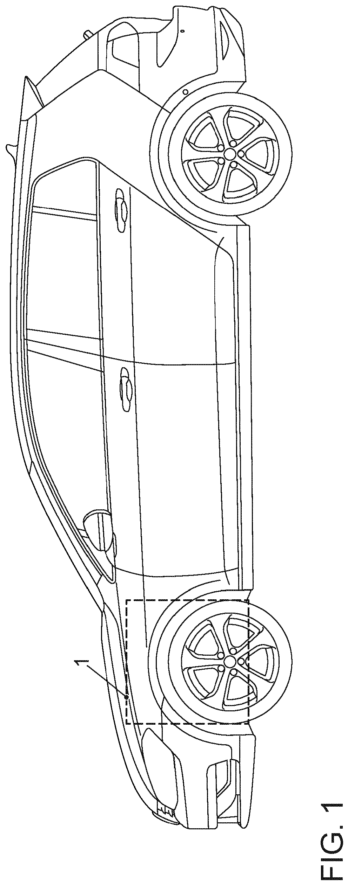

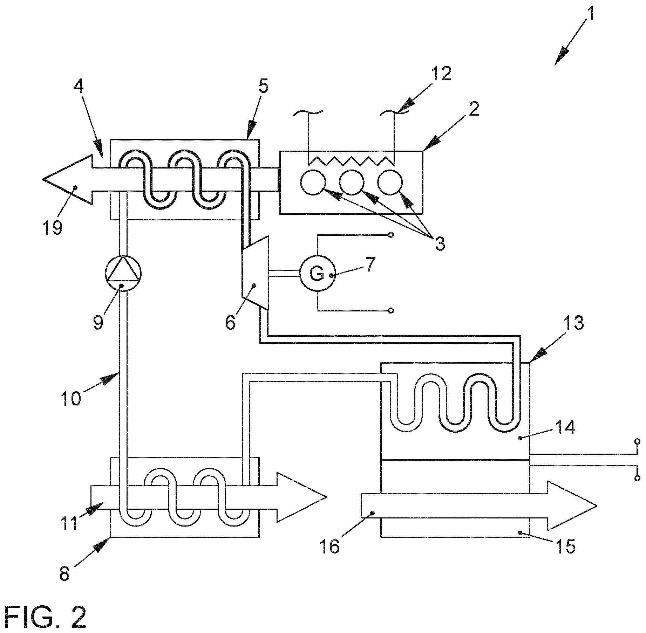

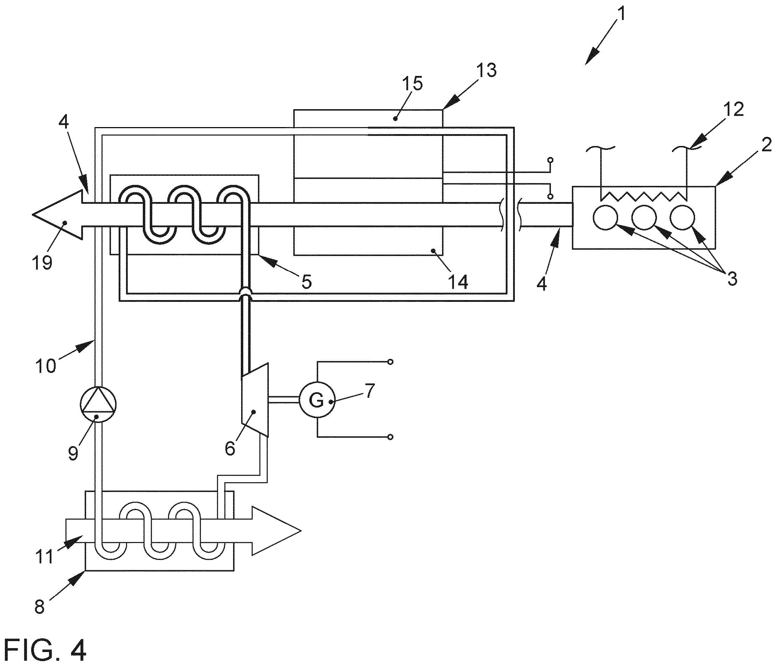

Die Fig. 1 zeigt ein (erfindungsgemäßes) Kraftfahrzeug mit einer erfindungsgemäßen Antriebseinheit. Diese Antriebseinheit 1 kann beispielsweise gemäß einer der in den Fig. 2, 3 und 5 dargestellten Ausgestaltungsformen ausgebildet sein. Die Antriebseinheit gemäß der Fig. 4 entspricht dagegen nicht mehr der in den Patentansprüchen definierten Ausgestaltung.

Die in den Fig. 2 bis 5 dargestellten Antriebseinheiten 1 umfassen jeweils eine Brennkraftmaschine mit einem Verbrennungsmotor 2, der beispielsweise als Diesel- oder Ottomotor ausgebildet ist. In dem Verbrennungsmotor 2 sind ein oder mehrere Brennräume 3 ausgebildet, in denen im Betrieb des Verbrennungsmotors 2 Frischgas (Luft) mit Kraftstoff verbrannt wird. Das Frischgas wird dabei dem Verbrennungsmotor 2 über einen nicht dargestellten Frischgasstrang zugeführt. Bei der Verbrennung des Frischgases mit dem Kraftstoff entstandenes Abgas wird über einen Abgasstrang 4 von dem Verbrennungsmotor 2 abgeführt und in die Umgebung eingeleitet. Dabei durchströmt das Abgas eine erste Wärmetauschvorrichtung 5 einer Kreisprozessvorrichtung, die konkret als Dampfkreisprozessvorrichtung ausgestaltet ist.

Die erste Wärmetauschvorrichtung 5 wird zum einen von dem Abgas und zum anderen (separiert voneinander) von einem Arbeitsmedium 10 der Kreisprozessvorrichtung durchströmt, wobei ein Wärmeübergang von dem Abgas auf das Arbeitsmedium erfolgt. Dieser Wärmeübergang führt zu einem Verdampfen und Überhitzen des Arbeitsmediums 10 in der als Verdampfer ausgeführten ersten Wärmetauschvorrichtung 5. In einem rechtsläufigen Kreisprozess kann der überhitzte Dampf anschließend in einer Expansionsvorrichtung 6 expandiert werden, wobei mechanische Leistung erzeugt wird, die wiederum zur Erzeugung von elektrischer Energie mittels eines Generators 7 genutzt werden kann. In einer zweiten Wärmetauschvorrichtung 8 der Kreisprozessvorrichtung, die als Kondensator dient, wird das Arbeitsmedium 10 anschließend gekühlt und wieder in die flüssige Phase überführt. Eine Pumpe 9 der Kreisprozessvorrichtung sorgt für das erneute Zuführen des flüssigen Arbeitsmediums 10 zu der ersten Wärmetauschvorrichtung (Verdampfer) 5, um den Kreislauf des Arbeitsmediums 10 in der Kreisprozessvorrichtung zu schließen.

Die zweite Wärmetauschvorrichtung (Kondensator) 8 wird neben dem Arbeitsmedium 10 auch (separiert voneinander) von einem Kühlmedium 11, beispielsweise von einer Kühlflüssigkeit, die in einem Motorkühlkreis eines Kühlsystems 12 der Brennkraftmaschine strömt, durchströmt, wobei während der Durchführung des Kreisprozesses mittels der Kreisprozessvorrichtung ein Wärmeübergang von dem Arbeitsmedium 10 auf das Kühlmedium 11 erfolgt.

Die Antriebseinheiten gemäß den Fig. 2 bis 5 umfassen jeweils auch einen thermoelektrischen Generator (TEG) 13, der derart in die Kreisprozessvorrichtung integriert ist, dass das Arbeitsmedium 10 auch über diesen geführt wird. Dies erfolgt, um mittels eines Wärmeübergangs zwischen dem Arbeitsmedium 10 und entweder einer Hochtemperaturseite 14 oder einer Niedertemperaturseite 15 des thermoelektrischen Generators 13 eine Temperaturdifferenz zwischen diesen Seiten des thermoelektrischen Generators 13 zu beeinflussen beziehungsweise zu generieren und aufrechtzuhalten. Dadurch kann mittels des TEG 13 eine elektrische Nutzleistung erzeugt werden, die beispielsweise in ein Bordnetz der Antriebseinheit beziehungsweise in ein Bordnetz eines die Antriebseinheit umfassenden Kraftfahrzeugs eingespeist werden kann. Die konkreten Arten der Integration des TEG 13 in die jeweilige Kreisprozessvorrichtung unterscheiden sich bei den Antriebseinheiten 1 gemäß den Fig. 2 bis 5.

Bei der Antriebseinheit 1 gemäß der Fig. 2 ist vorgesehen, dass das Arbeitsmedium 10 über die Hochtemperaturseite 14 des TEG 13 geführt ist. Dabei ist der TEG 13 beziehungsweise die Hochtemperaturseite 14 davon bezüglich der vorgesehenen Strömungsrichtung des Arbeitsmediums 10 in der Kreisprozessvorrichtung stromab der Expansionsvorrichtung 6 und stromauf der zweiten Wärmetauschvorrichtung (Kondensator) 8 angeordnet. Neben der Nutzung von Abwärme der Kreisprozessvorrichtung zur Erzeugung elektrischer Nutzleistung mittels des TEG 13 weist diese Anordnung den Vorteil auf, dass der TEG 13 das anschließend der zweiten Wärmetauschvorrichtung (Kondensator) 8 zuzuführende Arbeitsmedium 10 vorkühlt und dadurch eine Kondensation des Arbeitsmediums 10 in der zweiten Wärmetauschvorrichtung (Kondensator) 8 unterstützt. Dies kann insbesondere dann vorteilhaft sein, wenn es sich bei dem zur Kühlung des Arbeitsmediums 10 in der zweiten Wärmetauschvorrichtung (Kondensator) 8 genutzten Kühlmedium um Kühlflüssigkeit handelt, die in einem Motorkühlkreis eines Kühlsystems 12 der Brennkraftmaschine strömt und die dadurch regelmäßig eine relativ hohe Fluidtemperatur aufweist, was mit einer relativ geringen Kühlleistung dieser zweiten Wärmetauschvorrichtung (Kondensator) 8 einhergehen kann.

Bei dem Kühlmittel 16, das die Niedertemperaturseite 15 des TEG 13 durch- und/oder umströmt, kann es sich vorzugsweise um ein von der Kühlflüssigkeit des Kühlsystems 12 abweichendes Kühlmittel 16, beispielsweise um gezielt für die Kühlung der Niedertemperaturseite 15 des TEG 13 zugeführte Umgebungsluft, handeln. Dieses Kühlmittel 16 kann dadurch in vorteilhafter Weise eine im Vergleich zu der Kühlflüssigkeit des Kühlsystems 12 relativ niedrige Fluidtemperatur aufweisen, was zu einer möglichst großen Temperaturdifferenz zwischen der Hochtemperaturseite 14 und der Niedertemperaturseite 15 des TEG 13 und damit zu einer möglichst großen mittels des TEG 13 generierbaren elektrischen Nutzleistung führen kann.

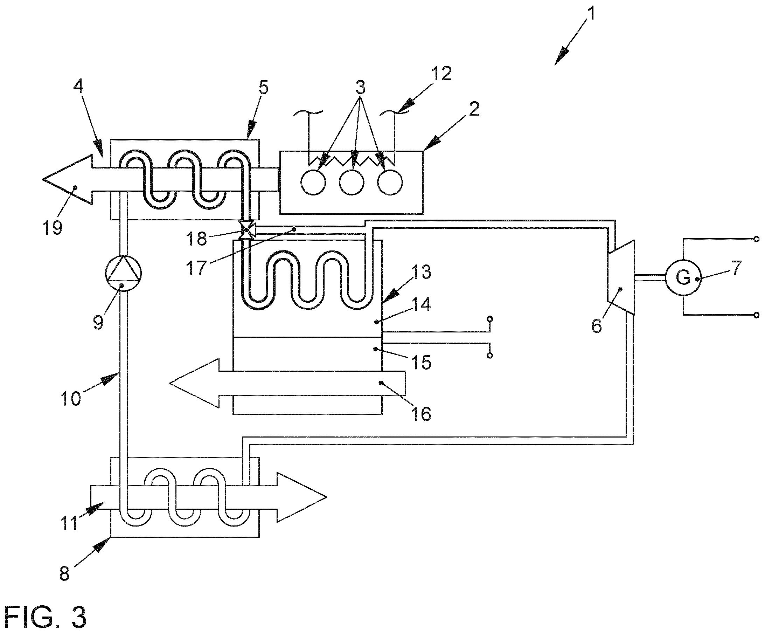

Die in der Fig. 3 dargestellte Antriebseinheit 1 unterscheidet sich von derjenigen gemäß der Fig. 2 lediglich in der Anordnung des TEG 13. In diesem Fall ist die wiederum von dem Arbeitsmedium 10 der Kreisprozessvorrichtung durchströmte Hochtemperaturseite 14 des TEG 13 bezüglich der Strömungsrichtung des Arbeitsmediums 10 stromab der ersten Wärmetauschvorrichtung (Verdampfer) 5 und stromauf der Expansionsvorrichtung 6 angeordnet. Diese Anordnung weist zum einen den Vorteil auf, dass das durch die Hochtemperaturseite 14 des TEG 13 geführte Arbeitsmedium 10 eine relativ hohe Temperatur aufweist, die zu einer entsprechend hohen Temperaturdifferenz zwischen der Hochtemperaturseite 14 und der Niedertemperaturseite 15 des TEG 13 und daraus folgend zu einer entsprechend hohen Nutzleistung, die mittels des TEG 13 generiert werden kann, führt. Weiterhin kann durch diese Anordnung des TEG 13 erreicht werden, dass temporär vergleichsweise hohe Temperaturen des Arbeitsmediums 10, die aus einem entsprechend hohen Abgaswärmeangebot, das beispielsweise aus einem Betrieb des Verbrennungsmotors 2 mit hohen und insbesondere maximalen Lasten und Drehzahlen resultiert, mittels des TEG 13 reduziert werden, bevor das Arbeitsmedium 10 die Expansionsvorrichtung 6 erreicht. Dies kann insbesondere vorteilhaft sein, wenn die Expansionsvorrichtung 6 hinsichtlich eines möglichst hohen Wirkungsgrads bei einem eher durchschnittlichen Abgaswärmeangebot ausgelegt ist. Eine solche Auslegung der Expansionsvorrichtung 6 beziehungsweise der gesamten Kreisprozessvorrichtung kann vorteilhaft sein, weil Verbrennungsmotoren, die zum Antrieb von Kraftfahrzeugen vorgesehen sind, üblicherweise die meiste Zeit in einem Teillastbetrieb genutzt werden, so dass es sinnvoll sein kann, die Kreisprozessvorrichtung derart auszulegen, dass diese bei einem in einem solchen Teillastbetrieb bereitgestellten Abgaswärmeangebot einen möglichst hohen Wirkungsgrad erzielt.

Insbesondere bei dieser Antriebseinheit 1 gemäß der Fig. 3 kann es sinnvoll sein, eine Durchströmung der Hochdruckseite 14 des TEG 13 temporär zumindest teilweise zu verhindern, indem das Arbeitsmedium 10 zumindest teilweise über einen Bypass 17 zu dem TEG 13 geführt wird. Dies ist mittels eines entsprechenden Steuerventils 18 einstellbar. Dadurch kann die Menge der Wärmeenergie des Arbeitsmediums 10, die in dem TEG 13 zur Erzeugung elektrischer Nutzleistung genutzt wird und die dadurch nicht mehr für eine Nutzung in der Expansionsvorrichtung 6 zur Verfügung steht, bedarfsgerecht gesteuert werden.

Bei dem Kühlmittel 16, das die Niedertemperaturseite 15 des TEG 13 durch- und/oder umströmt, kann es sich wiederum vorzugsweise um ein von der Kühlflüssigkeit des Kühlsystems 12 abweichendes Kühlmittel 16, beispielsweise um gezielt zugeführte Umgebungsluft handeln. Dieses Kühlmittel 16 kann in vorteilhafter Weise eine im Vergleich zu der Kühlflüssigkeit des Kühlsystems 12 relativ niedriger Fluidtemperatur aufweisen, was zu einer möglichst großen Temperaturdifferenz zwischen der Hochtemperaturseite 14 und der Niedertemperaturseite 15 und damit zu einer möglichst großen mittels des TEG 13 generierbaren, elektrischen Nutzleistung führen kann.

Bei der Antriebseinheit 1 gemäß der Fig. 4 wird das Arbeitsmedium 10 der Kreisprozessvorrichtung über die Niedertemperaturseite 15 des TEG 13 geführt. Die Hochtemperaturseite 14 des TEG 13 wird dagegen direkt von dem Abgas 19 durch- und/oder umströmt. Dies erfolgt, bevor das Abgas 19 die erste Wärmetauschvorrichtung (Verdampfer) 5 der Kreisprozessvorrichtung durchströmt. Dies führt einerseits zu einer relativ hohen Temperatur auf der Hochtemperaturseite 14 des TEG 13 und damit zu einer entsprechend hohen Temperaturdifferenz zwischen der Hochtemperaturseite 14 und der Niedertemperaturseite 15. Die mittels des TEG 13 realisierbare Nutzleistung kann daher entsprechend hoch sein. Gleichzeitig kann Wärmeenergie, die in der Niedertemperaturseite 15 des TEG 13 auf das Arbeitsmedium 10 übertragen wird, in vorteilhafter Weise dazu genutzt werden, das Arbeitsmedium 10 vorzuwärmen, bevor dieses in die erste Wärmetauschvorrichtung (Verdampfer) 5 der Kreisprozessvorrichtung eintritt. Dementsprechend ist gemäß der Fig. 4 vorgesehen, dass der TEG 13 beziehungsweise dessen Niedertemperaturseite 15 in einer Anordnung stromab der zweiten Wärmetauschvorrichtung (Kondensator) 8 und stromauf der ersten Wärmetauschvorrichtung (Verdampfer) 5 in den Kreislauf der Kreisprozessvorrichtung integriert ist.

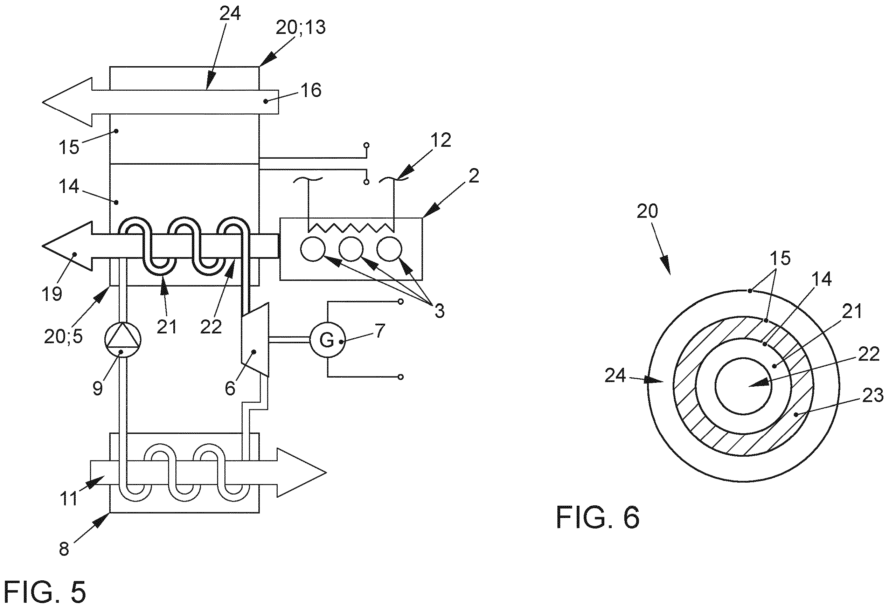

Bei der Antriebseinheit gemäß der Fig. 5 ist eine integrale Ausbildung der ersten Wärmetauschvorrichtung (Verdampfer) 5 der Kreisprozessvorrichtung und des TEG 13 in einer Wärmetauscheinheit 20 vorgesehen, bei der ein zur Durchströmung mit dem Arbeitsmedium 10 vorgesehener Arbeitsmediumkanal 21 der ersten Wärmetauschvorrichtung (Verdampfer) 5 zwischen einem zur Durchströmung mit dem Abgas 19 vorgesehenen Abgaskanal 22 einerseits und der Hochtemperaturseite 14 des TEG 13 andererseits angeordnet ist. Konkret kann hierfür gemäß der Fig. 6 vorgesehen sein, dass der Abgaskanal 22 von dem ringförmigen Arbeitsmediumkanal 21 umfangseitig umgeben ist. Der Arbeitsmediumkanal 21 ist dabei außen- bzw. umfangsseitig von der Hochtemperaturseite 14 des TEG 13 begrenzt. Die Hochtemperaturseite 14 ist wiederum umfangsseitig von der Niedertemperaturseite 15 des TEG 13 umgeben, wobei eine Mehrzahl von Thermoelementen 23, die zur Ausbildung einer Thermokette in Reihe geschaltet sind, die Hochtemperaturseite 14 und die Niedertemperaturseite 15 des TEG 13 strukturell verbinden. Die Niedertemperaturseite 15 des TEG kann optional einen Kühlmittelkanal 24 umfassen, der ebenfalls ringförmig ausgebildet sein kann und durch den ein Kühlmittel 16 zur Kühlung der Niedertemperaturseite 15 des TEG 13 geführt werden kann.

Bei dem Kühlmittel 16, das bei der Antriebseinheit 1 gemäß der Fig. 5 die Niedertemperaturseite 15 des TEG 13 durch- und/oder umströmt, kann es sich wiederum vorzugsweise um ein von der Kühlflüssigkeit des Kühlsystems 12 abweichendes Kühlmittel 16, beispielsweise um gezielt zugeführte Umgebungsluft handeln.

### Bezugszeichenliste

- 1: Antriebseinheit
- 2: Verbrennungsmotor
- 3: Brennraum des Verbrennungsmotors
- 4: Abgasstrang
- 5: erste Wärmetauschvorrichtung
- 6: Expansionsvorrichtung
- 7: Generator
- 8: zweite Wärmetauschvorrichtung
- 9: Pumpe
- 10: Arbeitsmedium
- 11: Kühlmedium
- 12: Kühlsystem
- 13: thermoelektrischer Generator (TEG)
- 14: Hochtemperaturseite des thermoelektrischen Generators
- 15: Niedertemperaturseite des thermoelektrischen Generators
- 16: Kühlmittel
- 17: Bypass zu dem TEG
- 18: Steuerventil
- 19: Abgas
- 20: Wärmetauscheinheit
- 21: Arbeitsmediumkanal der ersten Wärmetauschvorrichtung
- 22: Abgaskanal der ersten Wärmetauschvorrichtung
- 23: Thermoelement
- 24: Kühlmittelkanal

## Patentansprüche

1. Antriebseinheit (1) für ein Kraftfahrzeug mit
- einer Brennkraftmaschine, die einen Verbrennungsmotor (2) sowie einen Abgasstrang (4), über den Abgas (19) von dem Verbrennungsmotor (2) abführbar ist, umfasst,
- einer Kreisprozessvorrichtung zur Wandlung von Wärmeenergie des Abgases (19) in einem thermodynamischen Kreisprozess in mechanische Arbeit, wobei ein Arbeitsmedium (10) bezüglich seiner Strömungsrichtung
- eine erste Wärmetauschvorrichtung (5) durchströmt, in der ein Wärmeübergang von dem Abgas (19) auf das Arbeitsmedium (10) erfolgt,
- anschließend eine Expansionsvorrichtung (6) durchströmt, in der eine Expansion des Arbeitsmediums (10) und dabei die Erzeugung der mechanischen Arbeit erfolgt, und
- anschließend eine zweite Wärmetauschvorrichtung (8) durchströmt, in der ein Wärmeübergang von dem Arbeitsmedium (10) auf ein Kühlmedium (11) erfolgt,
- einem thermoelektrischen Generator (13), der bei einer Temperaturdifferenz zwischen einer Hochtemperaturseite (14) und einer Niedertemperaturseite (15) eine elektrische Spannung bereitstellt,
wobei das Arbeitsmedium (10) der Kreisprozessvorrichtung auch über die Hochtemperaturseite (14) führbar ist,
**dadurch gekennzeichnet, dass**
eine Kühlung der Niedertemperaturseite (15) des thermoelektrischen Generators (13) mittels eines sich von dem Arbeitsmedium (10) unterscheidenden Kühlmittels erfolgt.

2. Antriebseinheit (1) gemäß Anspruch 1, **dadurch gekennzeichnet, dass** das Kühlmedium (11) auch über die Niedertemperaturseite (15) des thermoelektrischen Generators (13) führbar ist.

3. Antriebseinheit (1) gemäß Anspruch 1 oder 2, **dadurch gekennzeichnet, dass** das Kühlmedium (11) eine Kühlflüssigkeit eines Kühlsystems (12) der Brennkraftmaschine ist.

4. Antriebseinheit (1) gemäß einem der vorhergehenden Ansprüche, **gekennzeichnet durch** einen Bypass (17) für das Arbeitsmedium (10) zur bedarfsweisen Umgehung des thermoelektrischen Generators (13).

5. Antriebseinheit (1) gemäß einem der vorhergehenden Ansprüche, **dadurch gekennzeichnet, dass** der thermoelektrische Generator (13) bezüglich der Strömungsrichtung des Arbeitsmediums (10) stromab der Expansionsvorrichtung (6) und stromauf der zweiten Wärmetauschvorrichtung (8) angeordnet ist.

6. Antriebseinheit (1) gemäß einem der Ansprüche 1 bis 4, **dadurch gekennzeichnet, dass** der thermoelektrische Generator (13) bezüglich der Strömungsrichtung des Arbeitsmediums (10) stromab der ersten Wärmetauschvorrichtung (5) und stromauf der Expansionsvorrichtung (6) angeordnet ist.

7. Antriebseinheit (1) gemäß einem der Ansprüche 1 bis 4, **dadurch gekennzeichnet, dass** die erste Wärmetauschvorrichtung (5) und der thermoelektrische Generator (13) in einer Wärmetauscheinheit (20) integriert ausgebildet sind.

8. Antriebseinheit (1) gemäß Anspruch 7, **dadurch gekennzeichnet, dass** in der Wärmetauscheinheit (20) ein zur Durchströmung mit dem Arbeitsmedium (10) vorgesehener Arbeitsmediumkanal (21) der ersten Wärmetauschvorrichtung (5) zwischen einem zur Durchströmung mit dem Abgas (19) vorgesehenen Abgaskanal (22) einerseits und der Hochtemperaturseite (14) des thermoelektrischen Generators (13) andererseits angeordnet ist.

9. Antriebseinheit (1) gemäß Anspruch 8, **dadurch gekennzeichnet, dass** der Arbeitsmediumkanal (21) den Abgaskanal (22) umfangseitig umgibt und die Hochtemperaturseite (14) des thermoelektrischen Generators (13) den Arbeitsmediumkanal (21) umfangseitig umgibt.

10. Antriebseinheit (1) gemäß Anspruch 9, **dadurch gekennzeichnet, dass** die Niedertemperaturseite (15) die Hochtemperaturseite (14) des thermoelektrischen Generators (13) umfangseitig umgibt.

11. Kraftfahrzeug mit einer Antriebseinheit (1) gemäß einem der vorhergehenden Ansprüche.

## Claims

1. A drive unit (1) for a motor vehicle, comprising:
- an internal combustion engine which comprises a combustion engine (2) and an exhaust gas system (4) via which exhaust gas (19) can be discharged from the combustion engine (2),
- a circuit process device for converting thermal energy of the exhaust gas (19) in a thermodynamic circuit process into mechanical work, with a working medium (10), with respect to the flow direction thereof,
- flowing through a first heat exchange means (5) in which a heat transfer from the exhaust gas (19) to the working medium (10) takes place,
- subsequently flowing through an expansion device (6) in which an expansion of the working medium (10) and in the process the generation of the mechanical work takes place, and
- subsequently flowing through a second heat exchange means (8) in which a heat transfer from the working medium (10) to a cooling medium (11) takes place,
- a thermoelectric generator (13) which provides an electrical voltage in the event of a temperature difference between a high-temperature side (14) and a low-temperature side (15),
it being possible for the working medium (10) of the circuit process device to also be guided via the high-temperature side (14),
**characterized in that**
cooling of the low-temperature side (15) of the thermoelectric generator (13) is effected by means of a coolant differing from the working medium (10).

2. The drive unit (1) according to claim 1, **characterized in that** the cooling medium (11) can also be guided via the low-temperature side (15) of the thermoelectric generator (13).

3. The drive unit (1) according to either claim 1 or claim 2, **characterized in that** the cooling medium (11) is a cooling liquid of a cooling system (12) of the internal combustion engine.

4. The drive unit (1) according to any of the preceding claims, **characterized by** a bypass (17) for the working medium (10) for bypassing the thermoelectric generator (13) as required.

5. The drive unit (1) according to any of the preceding claims,
**characterized in that** the thermoelectric generator (13) is arranged downstream of the expansion device (6) and upstream of the second heat exchange means (8), with respect to the flow direction of the working medium (10).

6. The drive unit (1) according to any of claims 1 to 4, **characterized in that** the thermoelectric generator (13) is arranged downstream of the first heat exchange device (5) and upstream of the expansion device (6), with respect to the flow direction of the working medium (10).

7. The drive unit (1) according to any of claims 1 to 4, **characterized in that** the first heat exchange means (5) and the thermoelectric generator (13) are formed so as to be integrated in a heat exchange unit (20).

8. The drive unit (1) according to claim 7, **characterized in that** a working medium channel (21) of the first heat exchange device (5) provided for the working medium (10) to flow therethrough is arranged in the heat exchange unit (20), between, on the one hand, an exhaust gas duct (22) provided for the exhaust gas (19) to flow therethrough, and, on the other hand, the high-temperature side (14) of the thermoelectric generator (13).

9. The drive unit (1) according to claim 8, **characterized in that** the working medium channel (21) surrounds the exhaust gas duct (22) on the periphery, and the high-temperature side (14) of the thermoelectric generator (13) surrounds the working medium channel (21) on the periphery.

10. The drive unit (1) according to claim 9, **characterized in that** the low-temperature side (15) surrounds the high-temperature side (14) of the thermoelectric generator (13) on the periphery.

11. A motor vehicle comprising a drive unit (1) according to any of the preceding claims.

## Revendications

1. Unité d'entraînement (1) pour un véhicule automobile, comprenant
- un moteur à combustion interne, qui comprend un moteur à combustion (2) ainsi qu'une branche de gaz d'échappement (4), à travers laquelle du gaz d'échappement (19) peut être évacué du moteur à combustion (2),
- un dispositif de processus cyclique pour la transformation d'énergie thermique du gaz d'échappement (19) en travail mécanique dans un processus cyclique thermodynamique, un fluide de travail (10), par rapport à sa direction de circulation,
- traversant un premier dispositif d'échange thermique (5), dans lequel s'effectue un transfert de chaleur du gaz d'échappement (19) au fluide de travail (10),
- traversant ensuite un dispositif d'expansion (6), dans lequel s'effectue une expansion du fluide de travail (10) et, ce faisant, la génération du travail mécanique et
- traversant ensuite un deuxième dispositif d'échange thermique (8), dans lequel s'effectue un transfert de chaleur du fluide de travail (10) à un fluide de refroidissement (11),
- un générateur thermoélectrique (13), qui fournit une tension électrique lors d'une différence de température entre un côté haute température (14) et un côté basse température (15),
le fluide de travail (10) du dispositif de processus cyclique pouvant aussi être guidé sur le côté haute température (14),
**caractérisée en ce que**
un refroidissement du côté basse température (15) du générateur thermoélectrique (13) s'effectue au moyen d'un fluide de refroidissement différent du fluide de travail (10).

2. Unité d'entraînement (1) selon la revendication 1, **caractérisée en ce que** le fluide de refroidissement (11) peut aussi être guidé sur le côté basse température (15) du générateur thermoélectrique (13).

3. Unité d'entraînement (1) selon la revendication 1 ou 2,
**caractérisée en ce que** le fluide de refroidissement (11) est un liquide de refroidissement d'un système de refroidissement (12) du moteur à combustion interne.

4. Unité d'entraînement (1) selon l'une quelconque des revendications précédentes, **caractérisée par** une dérivation (17) pour le fluide de travail (10) pour le contournement, au besoin, du générateur thermoélectrique (13).

5. Unité d'entraînement (1) selon l'une quelconque des revendications précédentes, **caractérisée en ce que** le générateur thermoélectrique (13) est disposé, par rapport à la direction d'écoulement du fluide de travail (10), en aval du dispositif d'expansion (6) et en amont du deuxième dispositif d'échange thermique (8).

6. Unité d'entraînement (1) selon l'une quelconque des revendications 1 à 4, **caractérisée en ce que** le générateur thermoélectrique (13) est disposé, par rapport à la direction d'écoulement du fluide de travail (10), en aval du premier dispositif d'échange thermique (5) et en amont du dispositif d'expansion (6).

7. Unité d'entraînement (1) selon l'une quelconque des revendications 1 à 4, **caractérisée en ce que** le premier dispositif d'échange thermique (5) et le générateur thermoélectrique (13) sont conçus intégrés dans une unité d'échange thermique (20).

8. Unité d'entraînement (1) selon la revendication 7, **caractérisée en ce que,** dans l'unité d'échange thermique (20), un canal pour fluide de travail (21) du premier dispositif d'échange thermique (5), prévu pour le passage du fluide de travail (10), est disposé entre un canal pour gaz d'échappement (22) prévu pour le passage du gaz d'échappement (19) d'un côté et le côté haute température (14) du générateur thermoélectrique (13) de l'autre côté.

9. Unité d'entraînement (1) selon la revendication 8, **caractérisée en ce que** le canal pour fluide de travail (21) entoure le canal pour gaz d'échappement (22) sur sa circonférence et le côté haute température (14) du générateur thermoélectrique (13) entoure le canal pour fluide de travail (21) sur sa circonférence.

10. Unité d'entraînement (1) selon la revendication 9, **caractérisée en ce que** le côté basse température (15) entoure le côté haute température (14) du générateur thermoélectrique (13) sur sa circonférence.

11. Véhicule automobile doté d'une unité d'entraînement (1) selon l'une quelconque des revendications précédentes.
